Europäisches Patentamt

European Patent Office

Office européen des brevets

(11) Publication number: **0 292 059 B1**

# EUROPEAN PATENT SPECIFICATION

(45) Date of publication of patent specification: **01.04.92**   (51) Int. Cl.5: **H01L 25/04**, H01L 23/52

(21) Application number: **88200961.6**

(22) Date of filing: **13.05.88**

(54) Modular resin-encapsulated multi-chip circuit package and its manufacturing method.

(30) Priority: **18.05.87 IT 661187**

(43) Date of publication of application:
**23.11.88 Bulletin 88/47**

(45) Publication of the grant of the patent:
**01.04.92 Bulletin 92/14**

(84) Designated Contracting States:
**DE FR GB NL**

(56) References cited:
**EP-A- 0 058 852**
**GB-A- 1 187 595**
**GB-A- 2 084 796**

**PATENT ABSTRACTS OF JAPAN, vol. 9, no. 61 (E-303)[1784], 19th March 1985; & JP-A-59 198 748**

(73) Proprietor: **SGS-THOMSON MICROELECTRON-ICS s.r.l.**
**Via C. Olivetti, 2**
**I-20041 Agrate Brianza MI(IT)**

(72) Inventor: **Palara, Sergio**
**Via Livorno 103**
**I-95026 ACI Trezza CT(IT)**
Inventor: **Perniciaro Spatrisano, Antonio**
**Viale Lazio 30**
**I-90100 Palermo PA(IT)**
Inventor: **Paparo, Mario**
**Via Grassi 1**
**I-95037 San Giovanni La Punta CT(IT)**
Inventor: **Giacalone, Pietro**
**Via Verona 3**
**I-91026 Mazara Del Vallo TP(IT)**

(74) Representative: **Arena, Giovanni**
**Viale Certosa 135**
**I-20151 Milano(IT)**

EP 0 292 059 B1

## Description

This invention refers to a modular resin-encapsulated multi-chip circuit package and to its manufacturing method. In the manufacture of integrated circuit components, it is very often necessary to incorporate several chips into a single package in order to create a compact, complex system which would be impossible to achieve with a single chip.

According to the number of known soultion the system is achieved by means of a hybrid circuit comprising a single substrate of electrically insulating material, which frequently also serves as a heat sink, on which several reciprocally electrically insulated areas are created. Said components often include load current control circuits and devices for thermal protection of the systems obtained, said circuits and devices being realized on a same integrated circuit located on a same supporting plate, for example, as disclosed in GB-A-1 187 595.

It is known from JP-A-59 198 748 & Patent Abstracts of Japan, Vol.9, no.61 (E-303) (1784), 19.03.85 to adher two chips onto individual metal plates of a lead-frame, perform wire bonding between the chips and terminal leads and to integrally mold them with resin.

The scope of this invention is to provide a multi-chip circuit package which ensures an extremely high degree of reliability, and at the same time is simpler in structure and less expensive than the previous solutions, and which may be realized in a modular way.

For this purpose, the modular resin-encapsulated multi-chip circuit package according to this invention comprises the features as set out in claim 1.

A method for manufacturing the modular above resin-encapsulated multi-chip circuit package is set out in claim 2.

The features of the invention will be more clearly evident from the following description of a non-restrictive embodiment with reference to the accompanying drawings, in which:

Figs. 1a and 1b:
show examples of systems which can be achieved by means of multi-chip circuits incorporated in resin;

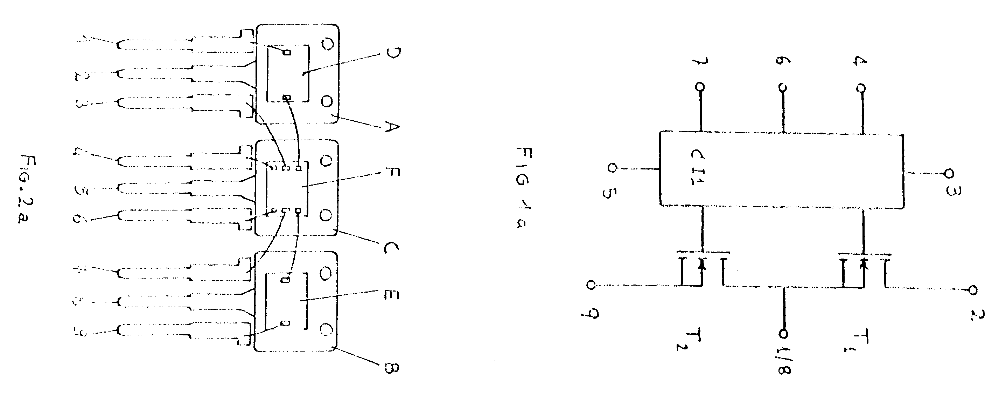

Figs. 2a and 2b:
show circuit embodiments, according to the invention, of the systems of Figs. 1a and 1b;

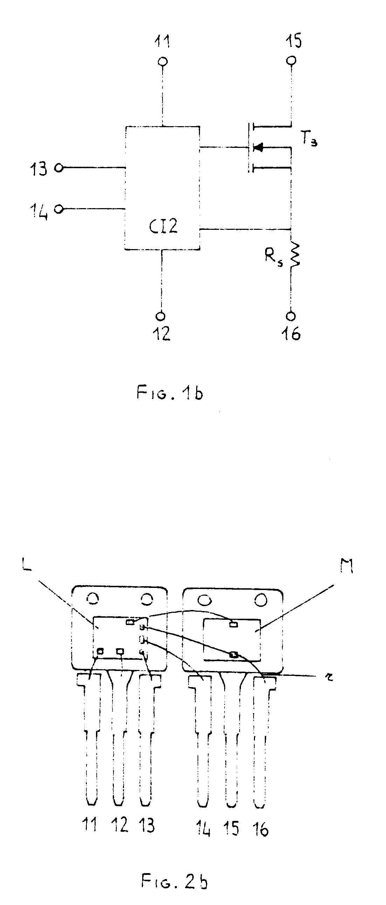

Fig.3:
shows a package relating to the circuit of Fig. 2a, as it appears after encapsulation in resin;

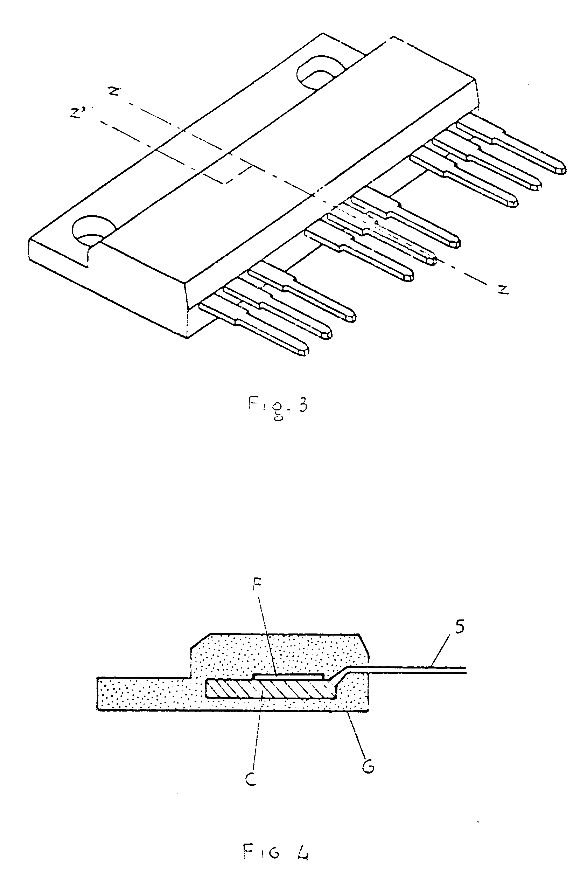

Fig.4:
shows a cross-sectional view of the package of Fig. 3;

Fig.5:
shows an embodiment, according to the invention, of the system of Fig. 1a, as it appears during a stage of the manufacturing process;

Fig.6:
shows a cross-sectional view of a die suitable for producing the modular circuit according to the invention.

Figs. 1a and 1b show examples of two possible systems which can both be obtained by means of a multi-chip circuit incorporated into a single package. More precisely, Fig.1a shows the layout of a semi-bridge circuit with $\overline{MOS}$ power transistors T1, T2 and with an integrated control circuit CI1, while Fig. 1b shows the layout of a voltage regulator with $\overline{MOS}$ power transistor T3, integrated control circuit CI2 and current sensing resistor Rs.

Fig.2a shows a circuit embodiment, according to the invention, of the layout of Fig. 1a. The various parts indicated therein have the following meaning:

D, E, F:
Chips in which the transistors T1 and T2 and the integrated circuit CI1 are implemented respectively;

2, 5, 8:
appendices of the plates A, C and B, acting as terminal leads of the chips D, F and E respectively;

1, 2, 4, 6, 7, 9:
laminar elements, made of the same conductive material as the plates A, B and C, acting as further terminal leads for the aforesaid chips.

Fig. 2a also shows the bonding wires constituting the connections between one chip and another and between chips and terminal leads.

Fia.2b shows a circuit embodiment, according to the invention, of the layout of Fig. 1b, in which L and M represent two chips constituting, respectively, the components CI2 and T3 of Fig. 1b, while the other parts have a wholly identical meaning to that (metal plates, terminal leads, bonding wires) of the parts likewise represented in Fig. 1a, with the exception of "r" which acts simultaneously as a bonding wire and as a resistor Rs.

Fig.3 shows the circuit of Fig. 2a as it appears after encapsulation in resin. The plates A, B and C are coplanar within the package. The plates are electrically insulated from one another and from the outside by means of the same insulating resin constituting the package. As can be seen in the cross-sectional view of the package shown in Fig.4 (cross-section along the line Z - Z of Fig. 3), the plates are positioned inside the package so as to present a uniform and sufficiently thin layer of resin on their face opposite that on which the chips are soldered. The purpose of this is to ensure a high degree of insulation and at the same time efficient dispersion of the heat towards an external securing and heat dissipation plate (not shown in the figure) on top of which the face G of the package is designed to be fitted.

The previously described multi-chip circuits are provided with an efficient device for thermal checking and protection of the systems obtained. In fact, taking as an example the layouts of Figs. 2a and 2b, it can be seen how the temperature sensor may be inserted into the integrated circuit. Thus, any rises in temperature over a given limit in the power elements on the chips D and E (Fig. 2a) or M (Fig. 2b), will, due to the excellent thermal conductivity of the resin, be immediately sensed by the adjacent sensor, which can thus come into operation to limit or interrupt the load current.

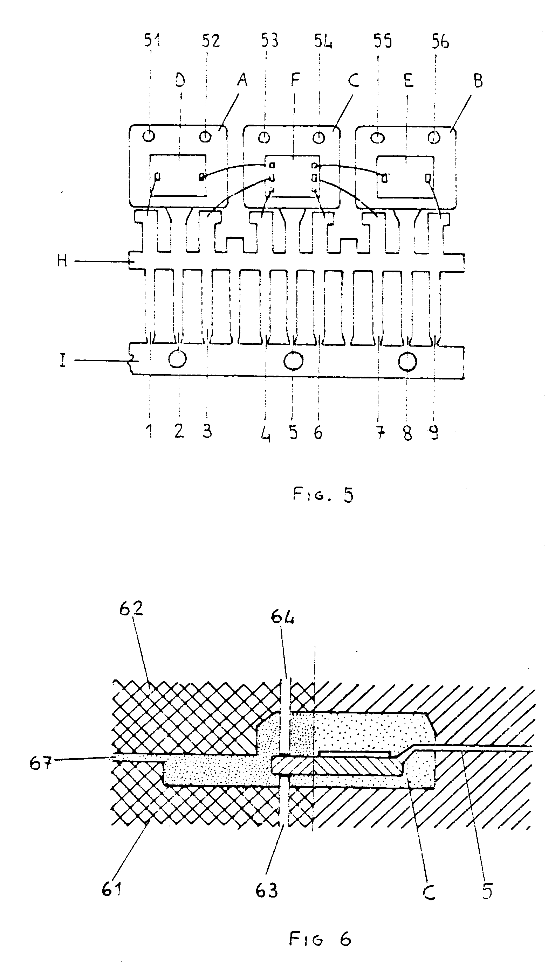

A description will now be given, with reference to Figs. 5 and 6, of a possible method for manufacturing the modular circuit according to the invention.

Fig.5 shows a framework consisting of a set of three metal plates A, B, C and a series of terminal leads 1, 2, ...., 9 which are obtained by cropping from a continuous strip. Said components are temporarily connected to one another by the strips H and I, which will later be removed by shearing after the encapsulation.

First the chips D, E, F are soldered onto the set of three plates A, B, C, followed by soldering of the bonding wires. The correct reciprocal positioning of the plates during the soldering of said wires is ensured by the use of a tool (not shown in the figures) capable of holding the entire framework and of engaging, by means of special catches, the slots 51, ..., 56 in the plates A, B, C.

The soldering stage of chips and bonding wires is followed by the encapsulation of the device in a transfer molding die, shown in cross-section in Fig.6 (cross-section along the line Z' - Z of Fig. 3). In said die the plate C is secured in the correct position on one side by the terminal lead 5, which is firmly held between the lower portion 61 and the upper portion 62 of the die, while on the other side, the plate is secured by means of a pair of upper 63 and lower 64 retractible ejector pins which are aligned with each other (only one of each pair of ejector pins is visible in the figure). Thus, with the plate correctly positioned and centered, the thermosetting resin can now be introduced into the die, through the inlet 67. As soon as the thermosetting reaction of the resin begins, the retractible pins 63 and 64 are extracted and the resin continues to be simultaneously introduced under pressure through 67, so as to fill the space in the die previously occupied by the aforesaid ejector pins.

After the encapsulation has been completed, the terminal leads are detached by shearing the relative connecting bridges consisting of the aforesaid strips H and I. It is clear that numerous modifications can be made to the embodiments previously described by way of pure example, and that some elements can be substituted with others having equivalent functions, without however deviating from the scope of the following claims. In particular, the correct positioning of the plates in the die can be ensured on one side by first locators provided in the die for the terminal leads leading to the plates and on the other side by second locators provided in the die for certain areas of the plates, and that, instead of being mobile as in the previous case, they can be fixed.

**Claims**

1. Modular resin-encapsulated multi-chip circuit package comprising several metal plates, at least one integrated circuit chip being soldered onto each of said metal plates, and several terminal leads, some of which are electrically connected to the aforesaid plates and others are electrically connected by bonding wires to said chips, with resin constituting the encapsulation and ensuring that the metal plates and said chips thereon are insulated from each other and with the said metal plates disposed in the same plane and with the said chips soldered thereto disposed on the same side of the aforesaid metal plates, characterized in that the said metal plates, on the side opposite to the said soldered chips, are insulated from the outside by a thin layer of the said resin constituting the encapsulation, and that a number of said chips are load current control circuits and another number of said chips are active power elements, the said metal plates bearing the load circuit control circuits alternating in succession with the said metal plates bearing the active power elements, said load current control circuits being electrically connected, within the package, to adjacent ones of said active power elements, and in that the load circuit control circuits have a temperature sensor so as to limit or interrupt the load current of the said adjacent active power elements, whenever the temperature rises above a given limit.

2. Method for manufacturing a modular resin-encapsulated multi-chip circuit package, as claimed in Claim 1, characterized by the fact that the correct positioning of the metal plates in a transfer molding die used for the resin encapsulation, is ensured, during one or more stages of the encapsulation process, by locators provided in the transfer molding die for the terminal leads leading to each metal plate and for given areas of the metal plates themselves, the locators provided for given areas of the metal plates being realized by retractable ejector pins, which are extracted from the molding die as soon as the thermosetting reaction of the resin begins.

## Revendications

1. Boîtier de circuit modulaire à plusieurs puces encapsulé dans de la résine comprenant plusieurs plaques métalliques, au moins une puce de circuit intégré étant soudée sur chacune desdites plaques métalliques, et plusieurs cosses de connexion, dont certaines sont électriquement connectées aux plaques susmentionnées et dont les autres sont électriquement connectées par des fils de liaison aux puces, de la résine constituant l'encapsulation et assurant que les plaques métalliques et lesdites puces sur celles-ci sont isolées les unes des autres, lesdites plaques métalliques étant disposées dans le même plan et lesdites puces leur étant soudées étant disposées du même côté des plaques métalliques susmentionnées, caractérisé en ce que lesdites plaques métalliques du côté opposé desdites puces soudées sont isolées de l'extérieur par une mince couche de ladite résine constituant l'encapsulation, en ce que plusieurs desdites puces sont des circuits de commande de courant de charge et d'autres desdites puces sont des éléments de puissance actifs, lesdites plaques métalliques portant les circuits de commande du circuit de charge alternant successivement avec les plaques métalliques portant les éléments de puissance actifs, les circuits de commande de courant de charge étant électriquement connectés, dans le boîtier, à des éléments de puissance actifs adjacents, et en ce que les circuits de commande de courant de charge comprennent un détecteur de température de façon à limiter ou interrompre le courant de charge des éléments de puissance actifs adjacents, chaque fois que la température monte au-dessus d'une limite déterminée.

2. Procédé pour fabriquer un boîtier de circuit modulaire à plusieurs puces encapsulé dans de la résine selon la revendication 1, caractérisé en ce que le positionnement correct des plaques métalliques dans un moule de transfert utilisé pour l'encapsulation de résine est assuré, pendant une ou plusieurs étapes du processus d'encapsulation, par des moyens de positionnement prévus dans le moule de transfert pour les cosses de connexion conduisant à chaque plaque métallique et pour des zones données des plaques métalliques elles-mêmes, les moyens de positionnement prévus pour des zones données des plaques métalliques étant réalisés par des ergots éjecteurs rétractables qui sont extraits du moule dès que la réaction de thermodurcissement de la résine commence.

## Patentansprüche

1. Harzumhüllter Mehrchip-Schaltungsmodul, enthaltend mehrere Metallplättchen, wobei auf jedem der Metallplättchen mindestens ein integrierter Schaltungschip aufgebracht ist, und mehrere Anschlußleiter, von denen einige elektrisch mit den vorgenannten Plättchen verbunden sind und andere mittels Verbindungsdrähten elektrisch mit den Chips verbunden sind, wobei Harz die Umhüllung bildet und sicherstellt, daß die Metallplättchen und die Chips darauf voneinander isoliert sind, und wobei die Metallplättchen in der gleichen Ebene angeordnet sind und wobei die darauf aufgebrachten Chips auf der gleichen Seite der Metallplättchen angeordnet sind, **dadurch gekennzeichnet,** daß die Metallplättchen auf der den aufgebrachten Chips gegenüberliegenden Seite gegen die Außenseite durch eine dünne Schicht des die Umhüllung bildenden Harzes isoliert sind, und daß eine Anzahl der Chips Laststromsteuerungsschaltungen sind und eine andere Anzahl der Chips aktive Leistungselemente sind, wobei sich die die Laststromsteuerungsschaltungen tragenden Plättchen in der Folge mit den die aktiven Leistungselemente tragenden Plättchen abwechseln, wobei die Laststromsteuerungsschaltungen innerhalb des Moduls elektrisch mit benachbarten der aktiven Leistungselemente verbunden sind, und daß die Laststromsteuerungsschaltungen einen Temperaturfühler aufweisen, um den Laststrom der benachbarten aktiven Leistungselemente zu begrenzen oder zu unterbrechen, wann immer die Temperatur über eine gegebene Grenze ansteigt.

2. Verfahren zur Herstellung eines harzumhüllten Mehrchip-Schaltungsmoduls nach Anspruch 1, **dadurch gekennzeichnet,** daß die korrekte Positionierung der Metallplättchen in einer für die Harzumhüllung verwendeten Übertragungsgußform während einer oder mehrerer Stufen des Umhüllungsvorgangs sichergestellt wird durch in der Übertragungsgußform für die zu jedem der Metallplättchen führenden Anschlußleiter und für bestimmte Bereiche der Metallplättchen selbst vorgesehene Lagefixierungseinrichtungen, wobei die für bestimmte Bereiche der Metallplättchen vorgesehenen Lagefixierungseinrichtungen durch zurückziehbare Ejektorstifte gebildet sind, die aus der Gußform zurückgezogen werden, sobald die Wär-
meaushärtungsreaktion des Harzes beginnt.

FIG 1a

FIG. 2a

Fig. 1b

Fig. 2b

Fig. 3

FIG 4

Fig. 5

Fig 6